# EUROPEAN PATENT APPLICATION

(11) **EP 4 503 148 A1**
(43) Date of publication of application: **05.02.2025**
(21) Application number: 23932695.2
(22) Date of filing: 29.08.2023
(51) Int. Cl.: H01L 31/20

(54) **LARGE-AREA DOUBLE-FREQUENCY THIN FILM DEPOSITION METHOD AND DEVICE FOR HETEROJUNCTION SOLAR CELL**

(30) Priority: 12.04.2023 CN 202310384880
(71) Applicant: Suzhou Maxwell Technologies Co., Ltd., Suzhou, Jiangsu 215200 (CN); Suzhou Maizheng Technology Co., Ltd, Suzhou, Jiangsu 215200 (CN)
(72) Inventor: WANG, Dengzhi, Suzhou, Jiangsu 215200 (CN); TIAN, Gangyu, Suzhou, Jiangsu 215200 (CN); WANG, Qingsong, Suzhou, Jiangsu 215200 (CN); ZHANG, Heng, Suzhou, Jiangsu 215200 (CN); HAN, Shaowen, Suzhou, Jiangsu 215200 (CN); QU, Qingyuan, Suzhou, Jiangsu 215200 (CN)
(74) Representative: Balder IP Law, S.L.
(86) International application number: PCT/CN2023/115572
(87) International publication number: WO 2024/212422

(57) **Abstract**

The present application discloses a large-area dual-frequency heterojunction solar cell thin film deposition method and apparatus, where the large-area dual-frequency heterojunction solar cell thin film deposition method at least includes: placing a silicon wafer to be deposited in a process chamber of a flat-plate coupled chemical vapor deposition; introducing a process gas into the process chamber, the process gas including at least one of SiH₄, H₂, CO₂, NO₂, N₂, O₂, O₃, Ar, and NH₃; generating a plasma by exciting and dissociating of the process gas through a radio frequency power supply system fed into the process chamber; and transferring the plasma to the surface of the silicon wafer to be deposited under the electric field to form a silicon-based thin film or perform plasma interface treatment on the deposited silicon-based thin film.

## Description

### TECHNICAL FIELD

The present application relates to the technical field of heterojunction solar cell manufacturing, and in particular, to a large-area dual-frequency heterojunction solar cell thin film deposition method and apparatus.

### BACKGROUND

In recent years, heterojunction solar cells have received extensive attention due to their higher conversion efficiency and stability. In order to reduce cost and increase efficiency and improve productivity, in the related art, in order to manufacture a large-capacity heterojunction solar cell, a Plasma Enhanced Chemical Vapor Deposition (PECVD) apparatus needs a larger apparatus chamber. On the one hand, using PECVD apparatus to deposit high-quality amorphous silicon thin film, or microcrystalline silicon thin film directly affects the performance of HJT solar cells. On the other hand, in order to reduce cost and increase efficiency, a large-area PECVD apparatus chamber is designed to improve the yield of single-process cell chip, thereby improving the device capacity.

In the related art, it is difficult to obtain a high deposition rate using the PECVD apparatus of RF-PECVD; however, the deposition rate can be improved by using the PECVD apparatus of VHF-PECVD. But due to skin effect, edge effect, standing wave effect and other electromagnetic effects, the increase of power frequency will aggravate the non-uniformity of plasma, especially for thin film solar cells, when a large area film is deposited, the plate size is larger and the uniformity of the film is more difficult to meet the requirements.

In the related art, a RF power supply (radio frequency power supply) and a VHF power supply (very high frequency power supply) are often fed together into the circuit of a discharge electrode, but the scheme does not further give how a RF power source and a VHF power source match in frequency and how to adapt to a PECVD apparatus so as to make same suitable for large-area film deposition production in a thin film solar cell manufacturing scenario, especially for films deposition production of heterojunction solar cell.

Therefore, in view of how to solve the technical problem in the related art, which is suitable for the uneven deposition production of a large-area deposition film in the manufacturing scene of a thin film solar cell, an effective solution has not yet been proposed.

### SUMMARY

The summary of the present application is provided to introduce a selection of concepts in a simplified form that are further described below in the Detailed Description. The summary of the present application is not intended to identify key features or essential features of the claimed technical solution, nor is it intended to be used to limit the scope of the claimed technical solution.

Some embodiments of the present application propose a large-area dual-frequency heterojunction solar cell thin film method and apparatus to solve the technical problem of nonuniform film in the production of a large-area film deposition.

As a first aspect of the present application, some embodiments of the present application provide a large-area dual-frequency heterojunction solar cell thin film deposition method including at least:
placing a silicon wafer to be deposited in a process chamber of a flat-plate coupled chemical vapor deposition;
a process gas is introduced into the process chamber, the process gas including at least one of SiH₄, H₂, CO₂, NO₂, N₂, O₂, O₃, Ar and NH₃;
generating a plasma by exciting and dissociating of the process gas through a radio frequency power supply system fed into the process chamber; and
transferring the plasma to the surface of the silicon wafer to be deposited under the electric field to form a silicon-based thin film or perform plasma interface treatment on the deposited silicon-based thin film; where
a radio frequency power supply system includes a first power source, and a second power source with a higher frequency than the first power source, and the value of the frequency ratio of the first power source to the second power source ranges from 1: 50 to 1: 1.5, and the frequency of the radio frequency power sources ranges from 0.3 MHz to 200 MHz;
the radio frequency power supply system is electrically connected to a first discharge electrode, and the first discharge electrode includes:
   a cathode with multiple apertures structure, a cathode backplate enclosing a gas distribution space with the cathode, and a channel portion located at the center of the cathode backplate for gas to enter the gas distribution space;
   the silicon wafer to be deposited is placed on a tray as a second discharge electrode, and the second discharge electrode is grounded;
   during the thin film deposition, an electrode spacing formed between the cathode of the first discharge electrode and the second discharge electrode ranges from 5 mm to 50 mm;
   the silicon wafer substrate temperature in the process chamber ranges from 100°C to 300°C; the gas pressure in the process chamber ranges from 0.2 Torr to 15 Torr;
   the size of the first discharge electrode and the second discharge electrode ranges from 1 m to 4 m in length and from 1 m to 4 m in width; and
   the power of the first power source ranges from 250 W to 60 KW, and the power of the second power source ranges from 250 W to 60 KW; and

Further, the flow rate of SiH₄ in the process gas ranges from 10 sccm to 10000 sccm.

Further, the first power source and the second power source are fed together to the central region of the cathode backplate corresponding to the channel portion;
or, the second power source is fed to the central region of the cathode backplate corresponding to the channel portion, and the first power source is fed to the edge region of the cathode backplate;
or, the first power source is electrically connected to the first discharge electrode, a third discharge electrode and a fourth discharge electrode are suspended in a discharge region formed by the first discharge electrode and the second discharge electrode, the second power source is electrically connected to the third discharge electrode, and the fourth discharge electrode is grounded.

Further, the first power source and the second power source have different turn-on time.

As a second aspect of the present application, some embodiments of the present application provide a large-area dual-frequency heterojunction solar cell thin film deposition apparatus for use in the above-mentioned large-area dual-frequency heterojunction solar cell thin film deposition method, the large-area dual-frequency heterojunction solar cell thin film deposition apparatus including:
a discharge electrode composed of a first discharge electrode and a second discharge electrode for generating an electric field for dissociating a gas; the size of the discharge electrode ranges from 1 m to 4 m in length and from 1 m to 4 m in width;
a process chamber for forming a region containing the discharge electrode;
a first power source for outputting a power of a first frequency; and
a second power source for outputting a power of a second frequency; the first power source and the second power source being both fed into the process chamber.

Further, the first discharge electrode includes: a cathode configured as a lowermost showerhead of the first discharge electrode, the process gas being ejected from the apertures; a cathode backplate enclosing a gas distribution space with the cathode; a channel portion configured to have at least one intake channel through which gas enters the gas distribution space; the channel portion is provided at a central region of the cathode backplate and at least partially outside the process chamber.

Further, the first power source and the second power source are electrically connected to the central region of the cathode backplate corresponding to the channel portion.

Further, the second power source is electrically connected to the central region of the cathode backplate corresponding to the channel portion; and the first power source is electrically connected to an edge region of the cathode backplate.

Further, the first power source is electrically connected to the cathode backplate in four places; where the connection positions of the first power source and the cathode backplate are symmetrically arranged on two diagonals of the cathode backplate.

Further, the first power source is electrically connected to the first discharge electrode, a third discharge electrode and a fourth discharge electrode are suspended in a discharge region formed by the first discharge electrode and the second discharge electrode, the second power source is electrically connected to the third discharge electrode, and the fourth discharge electrode is grounded, where the third discharge electrode and the fourth discharge electrode are strip antenna structure electrodes; the spacing between the first discharge electrode and the second discharge electrode ranges from 10 mm to 50 mm; and the spacing between the third discharge electrode and the fourth discharge electrode ranges from 5 mm to 45 mm.

Further, the large-area dual-frequency heterojunction solar cell thin film deposition apparatus further includes: a matching device for adjusting the impedance of the circuit where it is located; at least one of the first power source and the second power source is electrically connected to the discharge electrode through the matching device.

Further, the first power source and the second power source are respectively electrically connected to the discharge electrode via two different matching devices; or, the first power source and the second power source are electrically connected to the discharge electrode through the same matching device.

As a third aspect of the present application, some embodiments of the present application provide an in-line continuous deposition production equipment including the large-area dual-frequency heterojunction solar cell thin film deposition apparatus described above.

As a fourth aspect of the present application, some embodiments of the present application provide a cluster type deposition production equipment including the above-mentioned large-area dual-frequency heterojunction solar cell thin film deposition apparatus.

The beneficial effects of the present application are: a large-area dual-frequency heterojunction solar cell thin film deposition method that enables two output frequency power supplies to effectively feed the discharge electrodes in superposition to balance the efficiency and uniformity of the deposition.

### BRIEF DESCRIPTION OF DRAWINGS

The accompanying drawings, which are included to provide a further understanding of the present invention and are incorporated in and constitute a part of the present application, illustrate embodiments of the present invention and together with the description serve to explain the principles of the present invention. The drawings and their description illustrate exemplary embodiments of the present application, and are not to be construed as limiting the present application.

In addition, throughout the drawings, the same or similar reference numerals indicate the same or similar elements. It should be understood that the drawings are schematic and that components and elements are not necessarily drawn to scale.

In the drawings:
FIG. 1 is a schematic diagram showing main steps of a large-area dual-frequency heterojunction solar cell thin film deposition method according to an embodiment of the present application;
FIG. 2 is a schematic diagram showing specific steps of a large-area dual-frequency heterojunction solar cell thin film deposition method according to an embodiment of the present application.
FIG. 3 is a schematic structural diagram showing a large-area dual-frequency heterojunction solar cell thin film deposition method according to an embodiment of the present application;
FIG. 4 is a schematic structural diagram showing a large-area dual-frequency heterojunction solar cell thin film deposition method according to still another embodiment of the present application;
FIG. 5 is a partial schematic structural diagram of the embodiment shown in FIG. 4;
FIG. 6 is a schematic structural diagram showing a large-area dual-frequency heterojunction solar cell thin film deposition method according to still another embodiment of the present application;
reference numerals in the drawings are as follows:
100. thin film deposition apparatus;
101. first power source;
102. second power source;
103. first discharge electrode;
103a. channel portion;
103b. cathode backplate;
103c. cathode;
104. second discharge electrode;
105. matching device;
107. process chamber;
200. thin film deposition apparatus;
201. first power source;
202. second power source;
203. first discharge electrode;
203a. channel portion;
203b. cathode backplate;
203c. cathode;
203d. connecting portion;
C. central region of the cathode backplate;
S. edge region of the cathode backplate;
204. second discharge electrode;
205. first matching device;
206. second matching device;
207. process chamber;
207a. discharge region;
300. thin film deposition apparatus;
301. first power source;
302. second power source;
303. first discharge electrode;
303a. channel portion;
303b. cathode backplate;
303c. cathode;
304. second discharge electrode;
305. first matching device;
306. second matching device;
307. process chamber;
307a. discharge region;
308. third discharge electrode;
309. fourth discharge electrode;

### DETAILED DESCRIPTION OF THE EMBODIMENTS

Embodiments of the present disclosure will be described in more detail below with reference to the accompanying drawings. While certain embodiments of the disclosure have been illustrated in the accompanying drawings, it is to be understood that the disclosure may be embodied in various forms and should not be construed as limited to the embodiments set forth herein. Rather, these embodiments are provided so that the present disclosure will be thorough and complete. It should be understood that the drawings and examples of the present disclosure are for illustrative purposes only and are not intended to limit the scope of the present disclosure.

It is further noted that, for ease of description, only parts that are relevant to the present invention are shown in the drawings. The embodiments of the present disclosure and the features of the embodiments may be combined with each other without conflict.

It should be noted that references to "first", "second", and the like in the present disclosure are merely used to distinguish between different devices, modules, or units and are not intended to limit the order or interdependence of the functions performed by the devices, modules, or units.

It is noted that the references to "a", "an", and "a plurality" in the present disclosure are intended to be illustrative and not limiting, and a person skilled in the art will understand that "one or more" is to be interpreted unless the context clearly dictates otherwise.

The names of messages or information that interact between devices in embodiments of the present disclosure are for illustrative purposes only and are not intended to limit the scope of such messages or information.

The present disclosure will be described in detail below with reference to the accompanying drawings in conjunction with embodiments.

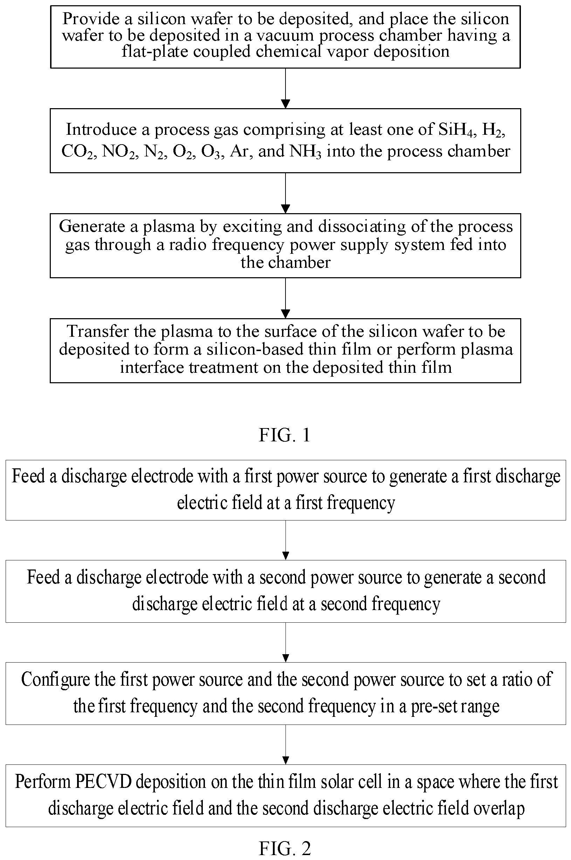

With reference to FIG. 1, there is provided a schematic diagram showing the main steps of a large-area dual-frequency heterojunction solar cell thin film deposition method, the thin film deposition method at least including: a silicon wafer to be deposited is placed in a process chamber of a flat-plate coupled chemical vapor deposition;
a process gas is introduced into the process chamber, the process gas including at least one of SiH₄, H₂, CO₂, NO₂, N₂, O₂, O₃, Ar and NH₃;
a plasma is generated by exciting and dissociating of the process gas through a radio frequency power supply system fed into the process chamber; and
the plasma is transferred to the surface of the silicon wafer to be deposited under the electric field to form a thin film or perform plasma interface treatment on the deposited thin film; where
a radio frequency power supply system includes a first power source, and a second power source with a higher frequency than the first power source, and the value of the frequency ratio of the first power source to the second power source ranges from 1: 50 to 1: 1.5, and the frequency of the radio frequency power sources range from 0.3 MHz to 200 MHz;
the radio frequency power supply system is electrically connected to a first discharge electrode, and the first discharge electrode includes:
   a cathode with multiple apertures structure, a cathode backplate enclosing a gas distribution space with the cathode, and a channel portion located at the center of the cathode backplate as an intake channel of a process chamber formed by gas entering the process chamber;
   the silicon wafer to be deposited is placed on a tray as a second discharge electrode, and the second discharge electrode is grounded;
   during the thin film deposition, an electrode spacing formed between the cathode of the first discharge electrode and the second discharge electrode ranges from 5 mm to 50 mm;
   the temperature of the silicon wafer substrate in the process chamber ranges from 100°C to 300°C; the gas pressure in the process chamber ranges from 0.2 Torr to 15 Torr; the size of the first discharge electrode and the second discharge electrode ranges from 1 m to 4 m in length and from 1 m to 4 m in width; the power of the first power source ranges from 250 W to 60 KW, and the power of the second power source ranges from 250 W to 60 KW.

As a specific solution, the second power source is fed to the central region of the cathode backplate and the first power source is fed to the edge region of the cathode backplate.

As a specific solution, the first power source is electrically connected to the first discharge electrode, a third discharge electrode and a fourth discharge electrode are suspended in a discharge region formed by the first discharge electrode and the second discharge electrode, the second power source is electrically connected to the third discharge electrode, and the fourth discharge electrode is grounded.

As a specific solution, the first power source and the second power source have different turn-on time.

Thus, since turning on may cause instability of the power source, and the two power sources interact with each other to cause the ignition failure, the first power source at a low frequency and the second power source at a high frequency are usually turned on at intervals.

Some embodiments of the present application provide a large-area dual-frequency heterojunction solar cell thin film deposition production equipment for the above-mentioned large-area dual-frequency heterojunction solar cell thin film deposition method, the large-area dual-frequency heterojunction solar cell thin film deposition apparatus including:
a discharge electrode composed of a first discharge electrode and a second discharge electrode for generating an electric field for dissociating a gas; the size of the discharge electrode ranges from 1 m to 4 m in length and from 1 m to 4 m in width;
a process chamber for forming a region containing the discharge electrode;
a first power source for outputting a power of a first frequency; and
a second power source for outputting a power of a second frequency; the first power source and the second power source being both fed to the process chamber.

Specifically, the first discharge electrode includes: a cathode, a cathode backplate and a channel portion, where the cathode is configured as a lowermost showerhead of the first discharge electrode, the process gas being ejected from the apertures; a cathode backplate enclosing a gas distribution space with the cathode; a channel portion configured to have at least one intake channel through which gas enters the gas distribution space; the channel portion is provided at a central region of the cathode backplate and at least partially outside the process chamber.

As a specific solution, the first power source and the second power source are electrically connected to the central region of the cathode backplate.

As a specific solution, the second power source is electrically connected to the central region of the cathode backplate; and a first power source is electrically connected to an edge region of the cathode backplate.

As a specific solution, the first power source is electrically connected to the cathode backplate in four places; where the connection positions of the first power source and the cathode backplate are symmetrically arranged on two diagonals of the cathode backplate.

It needs to be stated that the first discharge electrode in the present application is rectangular, and the first power source being divided into four parts and electrically connected to the cathode backplate means that the connection between the first power source and the cathode backplate is symmetrically arranged on a diagonal of the cathode backplate.

Thus, due to the symmetrical arrangement of the connection positions, an equal proportion of the first power signal is fed into the cathode backplate, so that the deposition film is uniform, and as the frequency increases, the effect of feeding uniformly around becomes more and more obvious.

As a specific solution, the first power source is electrically connected to the first discharge electrode, a third discharge electrode and a fourth discharge electrode are suspended in a discharge region formed by the first discharge electrode and the second discharge electrode, the second power source is electrically connected to the third discharge electrode, and the fourth discharge electrode is grounded, where the third discharge electrode and the fourth discharge electrode are strip antenna structure electrodes; the spacing between the first discharge electrode and the second discharge electrode ranges from 10 mm to 50 mm; and the spacing between the third discharge electrode and the fourth discharge electrode ranges from 5 mm to 45 mm.

As a specific solution, the large-area dual-frequency heterojunction solar cell thin film deposition apparatus further includes: a matching device for adjusting the impedance of the circuit where it is located; at least one of the first power source and the second power source is electrically connected to the discharge electrode through the matching device.

As a specific solution, the first power source and the second power source are respectively electrically connected to the discharge electrode via two different matching devices; or, the first power source and the second power source are electrically connected to the discharge electrode through the same matching device.

As shown in FIG. 2, in a thin film deposition process, a first power source is used to feed to a discharge electrode so as to generate a first discharge electric field of a first frequency, and a second power source is used to feed to a discharge electrode so as to generate a second discharge electric field of a second frequency; the first power source and the second power source are configured to set the ratio of the first frequency and the second frequency in a preset range; and a thin film solar cell is PECVD deposited in a space where the first discharge electric field and the second discharge electric field overlap.

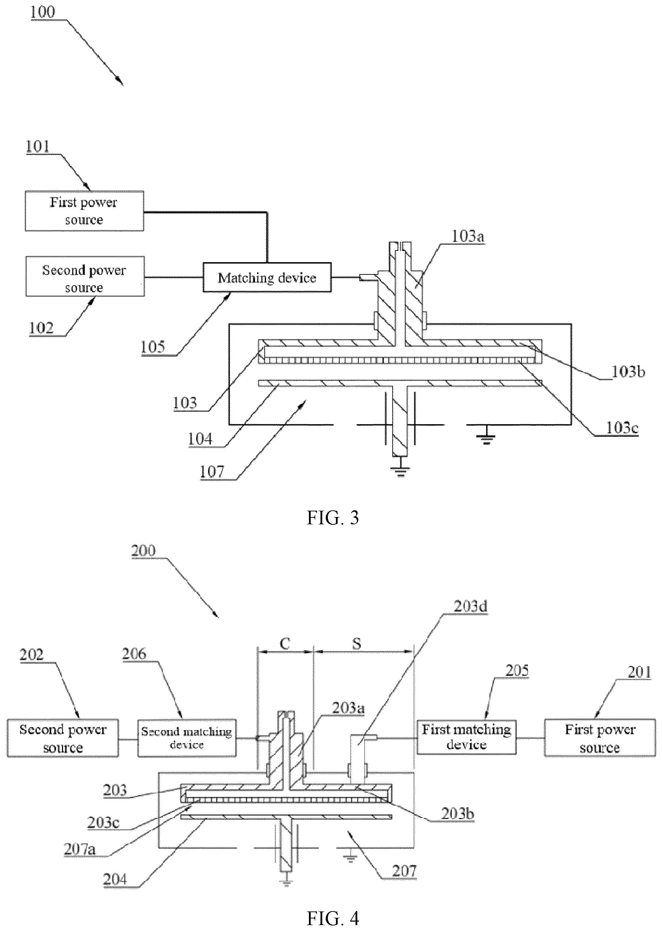

In addition, as to the feeding methods of the first power source and the second power source, electrical feeding can be performed in the following several ways, specifically as follows:
as an example, referring to FIG. 3, the thin film deposition apparatus 100 includes: a first power source 101, a second power source 102, a first discharge electrode 103, a second discharge electrode 104, a matching device 105, and a process chamber 107.

The first power source 101, the second power source 102, the second discharge electrode 104 and the process chamber 107 all use the same technical solution as the embodiment shown in FIG. 3, with the difference that the first discharge electrode 103 and the matching device 105 as well as the feeding manner of the first power source 101 and the second power source 102 are changed.

Specifically, the first power source 101 and the second power source 102 are both electrically connected to the central region of the first discharge electrode 103, i.e., the first power source 101 and the second power source 102 both centrally feed the first discharge electrode 103.

The first discharge electrode 103 includes: a channel portion 103a, a cathode backplate 103b, and a cathode 103c. The first discharge electrode 103 does not need to be edge fed. Both the first power source 101 and the second power source 102 are electrically connected to the channel portion 103a of the first discharge electrode 103 through the same matching device 105.

Referring to FIG. 4, a large-area dual-frequency heterojunction solar cell thin film deposition apparatus 200 includes: a first power source 201, a second power source 202, a first discharge electrode 203, a second discharge electrode 204, a first matching device 205, a second matching device 206, and a process chamber 207.

Specifically, the large-area dual-frequency heterojunction solar cell thin film deposition apparatus 200 is constructed as a PE-CVD apparatus.

As a specific solution, the first discharge electrode 203 and the second discharge electrode 204 in the process chamber 207 constitute a discharge region 207a. The process chamber 207 is also formed with a plurality of gas outlets to discharge gas. The silicon wafer to be deposited is placed on a tray as a second discharge electrode, and the second discharge electrode is grounded.

From the perspective shown in FIG. 4, the first discharge electrode 203 is arranged at the upper part of the discharge region, and the second discharge electrode 204 is arranged at the lower part of the discharge region; the first discharge electrode 203 and the second discharge electrode 204 equivalently constitute a capacitor, which forms a varying electric field after electrification so as to electrolyze the reaction gas into plasma so as to achieve film deposition, and this part of the principle is a technical solution well known to a person skilled in the art and will not be described in detail herein.

As a more specific solution, the first power source 201 and the second power source 202 are both electrically connected to the first discharge electrode 203 as a power source for generating an electric field, i.e., the first discharge electrode 203 serves as a cathode for discharging and the second discharge electrode 204 serves as an anode for discharging. The electrical connection referred to in the present application refers to a direct or indirect connection capable of transmitting electric energy, and the connection can be wired or coupled, for example, using a mutual inductance coil, etc.

The first power source 201 is used for outputting a power of a first frequency; the second power source 202 is arranged to output power at a second frequency. The first power source 201 and the second power source 202 are fed in superposition to the first discharge electrode 203.

The first frequency is different from the second frequency, i.e., the first power source 201 and the second power source 202 have different output frequencies. Specifically, the ratio of the first frequency to the second frequency ranges from 1: 50 to 1: 1.5.

As a further alternative, the frequency of the first power source 201 and the second power source 202 ranges between 0.3 MHz and 200 MHz.

As a preferred solution, the first power source 201 is configured as a radio frequency power source with an output frequency ranging from 1 MHz to 20 MHz. The second power source 202 is configured as a very high frequency power source with an output frequency ranging from 20 MHz to 200 MHz.

As a specific solution, the first frequency and the second frequency can adopt the following frequency configuration: 13.56 MHz: 27.12 MHz, 13.56 MHz: 40.68 MHz, 13.56 MHz: 60 MHz, 13.56 MHz: 200 MHz, 0.36 MHz: 1 MHz, 0.36 MHz: 2 MHz, 0.36 MHz: 13.56 MHz, 0.36 MHz: 27.12 MHz, 0.4 MHz: 1 MHz, 0.4 MHz: 2 MHz, 0.4 MHz: 13.56 MHz, 0.4 MHz: 27.12 MHz.

With the above solution, the first power source 201 and the second power source 202 are fed together into the first discharge electrode 203 using different output frequencies, so that the higher output frequency of the second power source 202 can be used to improve the efficiency of the dissociated gas, thereby improving the deposition efficiency; at the same time, using the lower output frequency of the first power source 201 can overcome the standing wave effect caused by the high frequency to a certain extent, so that the dissociated gas is more uniform, thereby improving the deposition uniformity. In order to achieve this, not all frequency-combined dual-frequency feeds are capable of achieving this. According to the research, it can be seen that the value range of the ratio of the output frequencies of the first power source 201 and the second power source 202 should be controlled ranging from 1: 50 to 1: 1.5; if it is less than 1: 50, the frequency difference between the two is large, the standing wave effect will increase with the geometric multiple of the VHF frequency, the auxiliary effect of the RF edge deposition is weakened, the central standing wave effect is strengthened, and the non-uniformity of the large-area PECVD deposition is increased; Excessive frequencies are prone to harmonic hazards, increasing device losses and potential safety hazards. On the contrary, if it is greater than 1: 1.5, the frequency difference between the two is small, the plasma concentration is not significantly increased, the film deposition rate is not improved, and the improvement of film uniformity is small.

Therefore, when dual-frequency feeding is used, it is necessary not only to use different frequencies, but also to use appropriate frequency matching to balance the efficiency and uniformity of deposition.

As a specific solution, as shown in FIG. 4, the second power source 202 is electrically connected to the central region C of the cathode backplate, and the first power source 201 is electrically connected to the edge region S of the first discharge electrode 203, and the edge region S of the first discharge electrode 203 referred to herein is arranged between the central region C of the cathode backplate and the edge of the first discharge electrode 203.

Thus, the feeding points of the first power source 201 and the second power source 202 are pulled apart by a certain distance to reduce electromagnetic interference.

It needs to be stated that on a large-area dimension, especially a dimension greater than 1 m × 1 m, and even on a large-area deposition film, the position of the feed-in point would directly affect the density of the plasma generated in the corresponding region thereof, and then affect the uniformity of the deposition film; the first discharge electrode 203 in the present application is rectangular, and the first power source 201 is divided into four parts and electrically connected to the cathode backplate 203b, which means that the connection between the first power source 201 and the cathode backplate is symmetrically arranged on the diagonal of the cathode backplate 203b.

Generally, the discharge electrode has a rectangular plate surface as a discharge interface, and the central region of the cathode backplate referred to herein refers to the center of the rectangular plate surface, i.e., the position where the diagonals of the rectangular plate surface intersect. The edge region of the cathode backplate refers to the cathode backplate beyond the central region on the cathode backplate.

As a specific solution, in order to ensure the uniformity of the gas inlet, it is generally desirable that the gas enters from the center of the process chamber 207, and accordingly, for the symmetry of the electric field, it is also desirable that the power can be fed centrally.

As shown in FIG. 4, as a preferred solution, the first discharge electrode 203 includes: a channel portion 203a, a cathode backplate 203b and a cathode 203c.

The cathode 203c is configured as the lowermost showerhead of the first discharge electrode, and the process gas is ejected from the apertures; a cathode backplate 203b encloses a gas distribution space with the cathode; the channel portion 203a is configured to have at least one intake channel for gas to enter the process chamber.

The channel portion 203a is provided at a position relatively at the center of the cathode backplate 203b and is at least partially located outside the process chamber 207; the second power source 202 is electrically connected to the channel portion 203a.

As further shown in FIG. 4, as a preferred solution, the first discharge electrode 203 further includes: a connecting portion 203d. The connecting portion 203d is used for connecting the first power source 201 to the cathode backplate 203b of the first discharge electrode 203; specifically, a portion of the connecting portion 203d is located outside the process chamber 207, and another portion of the connecting portion 203d is connected to a position other than the opposite center of the cathode backplate 203b. That is, the first power source 201 is electrically connected to the cathode backplate 203b at a position other than the opposite center thereof.

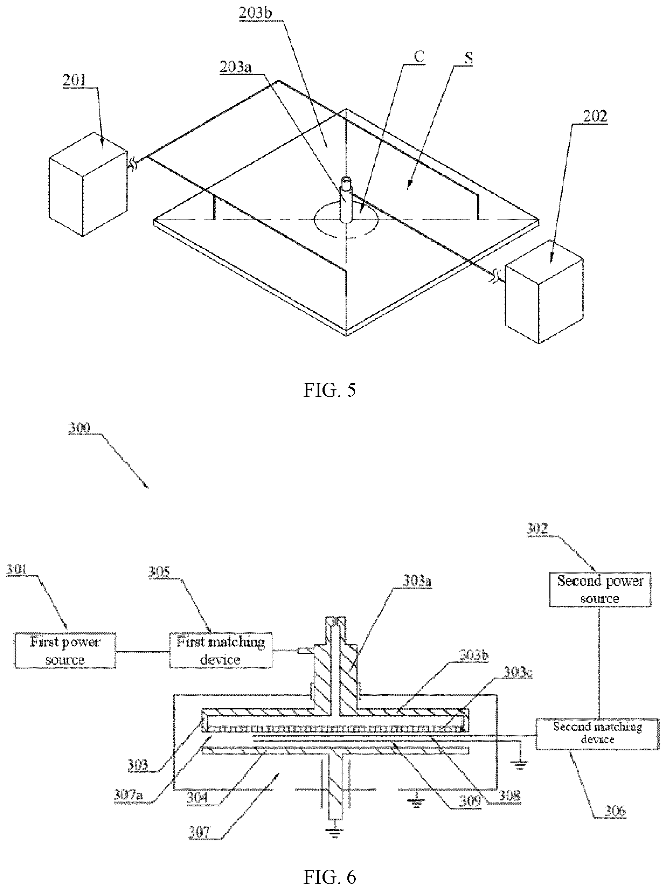

It should be noted that the "relative central position" referred to herein is equivalent to the "central region" described above. It should be noted that, since the channel portion 203a and the connecting portion 203d themselves have a certain volume, "the channel portion 203a is provided at the relative central position of the cathode backplate 203b" means to project in a direction perpendicular to the cathode 203c, and "the relative center of the cathode backplate 203b" is located in the projection range of the "channel portion 203a"; as a further preference, the projection of the "channel portion 203a" can take the relative center as a center of symmetry; similarly, the projection of the connecting portion 203d in this direction is covered outside the "opposite center of the cathode backplate 203b", i.e., "connected to the position outside the opposite center of the cathode backplate 203b", see FIG. 5. The first discharge electrode 203 is rectangular, and the first power source 201 is divided into four parts and electrically connected to the cathode backplate 203b, which means that the connection between the first power source 201 and the cathode backplate 203b is symmetrically arranged on a diagonal of the cathode backplate, and a uniformly distributed plasma is formed between the two polar plates to further improve the uniformity of the deposition film.

As a preferred solution, the thin film deposition apparatus 200 shown in FIG. 4 includes: a first matching device 205 and a second matching device 206. The first and second matching devices 205 and 206 function to adjust the impedance of the circuit on which they are located, thereby reducing the energy loss of the circuit. The first power source 201 and the second power source 202 are respectively electrically connected to different positions of the first discharge electrode 203 via the first matching device 205 and the second matching device 206, i.e., the first power source 201 and the second power source 202 are respectively electrically connected to the first discharge electrode 203 via two different matching devices. Specifically, the second power source 202 is electrically connected to the channel portion 203a of the first discharge electrode 203 through the second matching device 206, and the first power source 201 is electrically connected to the connecting portion 203d of the first discharge electrode 203 through the first matching device 205.

Referring to FIG. 6, as another embodiment of the present application, a thin film deposition apparatus 300 includes: a first power source 301, a second power source 302, a first discharge electrode 303, a second discharge electrode 304, a first matching device 305, a second matching device 306, and a process chamber 307.

The process chamber 307 may employ the same solution as the previously described embodiments of FIGS. 3 and 4.

Both the first power source 301 and the second power source 302 themselves can adopt the same technical solution as that of the embodiment shown in the foregoing FIGS. 1 and 2, and the first discharge electrode 303 and the second discharge electrode 304 can adopt the same technical solution as that of the embodiment shown in FIG. 2. The thin film deposition apparatus 300 differs in that it further includes: a third discharge electrode 308 and a fourth discharge electrode 309. The first power is fed to the center of the discharge electrode and the second power is fed to within the discharge region 307a, with the advantage that the position of the feed-in point of the second power is adjustable, and the distance from the feed-in point to the discharge electrode is controlled.

The third discharge electrode 308 and the fourth discharge electrode 309 are also provided in the provided discharge region 307a of the process chamber 307, which constitute a set of corresponding discharge electrodes, even if the third discharge electrode 308 is electrically connected to the second power source 302, but the fourth discharge electrode 309 is electrically connected to ground. The third discharge electrode 308 and the fourth discharge electrode 309 are provided in parallel and spatially overlap with the first discharge electrode 303 and the second discharge electrode 304, and in particular, the third discharge electrode 308 and the fourth discharge electrode 309 are each provided at a position between the first discharge electrode 303 and the second discharge electrode 304. Furthermore, the first power source 301 and the second power source 302 respectively use different matching devices to perform impedance adjustment, specifically, the first power source 301 feeds the first discharge electrode 303 via the first matching device 305; and the second power source 302 feeds the third discharge electrode 308 through the second matching device 306.

In this way, it is also possible to form a discharge electric field having a superposition effect using electrodes arranged in an overlapping manner so as to achieve the effect of multifrequency proportional feeding.

As an extension, in the solution shown in FIG. 6, the second power source 302 can directly power feed the third discharge electrode 308, i.e., the second power source 302 is directly electrically connected to the third discharge electrode 308 without passing through the matching device.

The first discharge electrode 303 includes: a channel portion 303a, a cathode backplate 303b, and a cathode 303c.

As a further specific solution, when the thin film deposition apparatus as shown in FIGS. 3, 4 and 6 is used, the deposition deposition method of the present application may, according to process requirements, introduce a gas such as SiH₄, H₂, PH₃, B₂H₆, CO₂, N₂O, CH₄, Ar, NH₃, O₂, O₃, H₂O, N₂, etc. from a channel portion, and set a required process gas pressure; and when the gas pressure is stable, the first power source and the second power source are started at the same time, where the first power source is set as a radio frequency power, and the frequency is 13.56 MHz. The second power source is set as a very high frequency power with a frequency of 27.12 MHz, and a high density and low electron temperature is generated in the process chamber due to the superposition of the discharge electric field generated by the first power source and the second power source to uniformly distribute the plasma between the two polar plates, thereby obtaining a high-quality amorphous/microcrystalline silicon thin film with a high deposition rate and uniformity.

As a further specific solution, when the thin film deposition apparatus as shown in FIGS. 3, 4 and 6 is used, the deposition and deposition method of the present application can, according to process requirements, introduce a gas such as SiH₄, H₂, PH₃, B₂H₆, CO₂, N₂O , CH₄, Ar, NH₃, O₂, O₃, H₂O, N₂, etc. from a channel portion, and set a required process gas pressure; after the gas pressure is stabilized, first a first power source is started, where the first power source is set as a radio frequency power, and the power frequency is 13.56 MHz; a plasma with a large area and uniform distribution is generated in the process chamber, and then a second power source is started, where the second power source is set as a very high frequency power with a frequency of 60 MHz; and a discharge electric field generated by the second power source further dissociates the generated plasma to obtain a high-quality amorphous/microcrystalline silicon thin film with a high deposition rate and uniform distribution.

As a further preferred solution, the first power source is a radio frequency power with a power ranging from 500 W to 60 kW, and the second power source is a very high frequency power with a power ranging from 1 kW to 30 kW; the temperature of the silicon wafer substrate in the process chamber ranges from 100°C to 300°C, and the gas pressure in the process chamber ranges from 0.3 Torr to 15 Torr; SiH₄ flow ranges 50 sccm to 10000 sccm, H₂ flow ranges from 1000 sccm to 300000 sccm.

As a further solution, the temperature value of the silicon wafer substrate in the process chamber ranges from 150°C to 280°C; the gas pressure in the process chamber ranges from 0.3 Torr to 12 Torr; the power of the first power source ranges from 300 W to 20 kW, the power of the second power source ranges from 300 W to 20 kW, and the SiH4 flow ranges from 10 sccm to 10000 sccm.

Specifically, the ratio of the first frequency to the second frequency is 1: 7.5 to 1: 1.5, such as 27.12 MHz: 40.68 MHz (1:1.5), 13.56 MHz: 27.12 MHz (1:2), 13.56 MHz: 40.68 MHz (1:3), 0.4 MHz: 2 MHz (1:5), 13.56 MHz: 100 MHz (1:7.37).

In addition to SiH₄ and H₂, the process chamber may be fed with: one or more of PH₃, B₂H₆, CO₂, N₂O , CH₄, Ar, NH₃, O₂, O₃, H₂O, and NH₃.

As a more specific technical solution, when the size of the discharge electrode is greater than or equal to one quarter of the radio frequency wavelength of the first power source, the second power source feeds the discharge electrode centrally. If such a solution is not followed, eccentricity of the deposition film may occur, the center symmetry may not be obtained, and the non-uniformity of the film may be increased.

With respect to the radio frequency wavelength of the first power source in which the size of the discharge electrode is smaller than a quarter, the influence on the deposition uniformity is small, so that the first power source with lower frequency can be edge-fed.

As a further preferred embodiment, the discharge electrode is a CCP plate discharge structure having a length of 1 m to 4 m and a width of 1 m to 4 m.

As a more specific preferred solution, for the solutions shown in FIGS. 3 and 4, the feeding of the power source may be through the cathode backplate of the discharge electrodes, the distance between the discharge electrodes, i.e. the distance of the discharge plane, ranges from 5 mm to 50 mm, and 10 mm to 35 mm.

For the feeding mode of the solution shown in FIG. 6, the second power source can be fed to multiple groups of corresponding discharge electrodes, i.e., a combination of multiple groups of third discharge electrodes and fourth discharge electrodes is provided, and at this time, the distance between the discharge electrodes fed by the first power source (a radio frequency power) ranges from 10 mm to 50 mm; the distance between the discharge electrodes fed by the second power source (very high frequency power) ranges from 5 mm to 45 mm. The discharge electrode fed by the second power source (very high frequency power) may also take the form of a cylindrical antenna structure.

As a specific solution, the present application also provides an in-line deposition production equipment including one or more of the aforementioned thin film deposition apparatuses or process chambers of the thin film deposition apparatuses.

As a specific solution, the present application also provides a cluster type deposition production equipment including one or more of the aforementioned thin film deposition apparatuses or process chambers of the thin film deposition apparatuses.

### Embodiment 1

Using the apparatus shown in FIG. 3, the amorphous silicon thin film is subjected to plasma interface treatment using the following process conditions: the electrode dimensions of the first discharge electrode 103 and the second discharge electrode 104 were 2.5 m in length and 2.5 m in width. The spacing between the cathode 103c and the second discharge electrode 104 is 20 mm, the ratio of the frequency of the first power source 101 to the frequency of the second power source 102 is 13.56 MHz: 40.68 MHz, the power of the first power source 101 is 2 kW, the power of the second power source is 8 kW, the temperature of the silicon wafer substrate is 180°C, SiH₄ with a flow rate of 5000 sccm is used as the process gas, and the gas pressure in the process chamber is 0.6 Torr.

### Embodiment 2

The amorphous silicon thin film deposition was carried out using the apparatus shown in FIG. 4 under the following process conditions: the electrode sizes of the first discharge electrode 203 and the second discharge electrode 204 are 1 m in length and 1 m in width. The spacing between the cathode 203c and the second discharge electrode 204 is 20 mm, the ratio of the frequency of the first power source 201 to the frequency of the second power source 202 is 13.56 MHz: 27.12 MHz, the power of the first power source 201 is 500 W, the power of the second power source 202 is 300 W, the temperature of the silicon wafer substrate is 190°C, SiH₄ with a flow rate of 1000 sccm is used as the process gas, and the gas pressure in the process chamber is 0.65 Torr.

### Embodiment 3

The amorphous silicon thin film deposition was carried out using the apparatus shown in FIG. 4 under the following process conditions: the electrode sizes of the first discharge electrode 203 and the second discharge electrode 204 are 1.5 m in length and 2 m in width. The spacing between the cathode 203c and the second discharge electrode 204 is 22 mm, the ratio of the frequency of the first power source 201 to the frequency of the second power source 202 is 13.56 MHz: 40.68 MHz, the power of the first power source 201 is 300 W, the power of the second power source 202 is 1 kW, the temperature of the silicon wafer substrate is 190°C, SiH₄ with a flow rate of 1000 sccm is used as a process gas, and the gas pressure in the process chamber is 8 Torr.

### Embodiment 4

The microcrystalline silicon thin film deposition was carried out using the apparatus shown in FIG. 4 under the following process conditions: the electrode sizes of the first discharge electrode 203 and the second discharge electrode 204 are 4m in length and 4m in width. The spacing between the cathode 203c and the second discharge electrode 204 is 10 mm, the ratio of the frequency of the first power source 201 to the frequency of the second power source 202 is 0.4 MHz: 2 MHz, the power of the first power source 201 is 20 kW, the power of the second power source 202 is 5 kW, the temperature of the silicon wafer substrate is 180°C, H₂ with a flow rate of 20000 sccm and SiH₄ with a flow rate of 75 sccm are used as a process gas, and the gas pressure in the process chamber is 12 Torr.

### Embodiment 5

The microcrystalline silicon thin film deposition was carried out using the apparatus shown in FIG. 4 under the following process conditions: the electrode sizes of the first discharge electrode 203 and the second discharge electrode 204 are 4m in length and 4m in width. The spacing between the cathode 203c and the second discharge electrode 204 is 25 mm, the ratio of the frequency of the first power source 201 to the frequency of the second power source 202 is 27.12 MHz: 40.68 MHz, the power of the first power source 201 is 15 kW, the power of the second power source is 18 kW, the temperature of the silicon wafer substrate is 150°C, siH₄ with a flow rate of 10000 sccm is used as a process gas, and the gas pressure in the process chamber is 1 Torr.

### Embodiment 6

Using the apparatus shown in FIG. 4 for operation, the amorphous silicon thin film is subjected to plasma interface treatment using the following process conditions: the electrode dimensions of the first discharge electrode 203 and the second discharge electrode 204 were 2.5 m in length and 2.5 m in width. The spacing between the cathode 203c and the second discharge electrode 204 is 35 mm, the ratio of the frequency of the first power source 201 to the frequency of the second power source 202 is 13.56 MHz: 100 MHz, the power of the first power source 201 is 4 kW, the power of the second power source is 20 kW, the temperature of the silicon wafer substrate is 280°C, H₂ with a flow rate of 5000 sccm is used as the process gas, and the gas pressure in the process chamber is 0.3 Torr.

### Embodiment 7

Using the apparatus shown in FIG. 4 for operation, the amorphous silicon thin film is subjected to plasma interface treatment using the following process conditions: the electrode dimensions of the first discharge electrode 203 and the second discharge electrode 204 were 2m in length and 2m in width. The spacing between the cathode 203c and the second discharge electrode 204 is 10 mm, the ratio of the frequency of the first power source 201 to the frequency of the second power source 202 is 27.12 MHz: 40.68 MHz, the power of the first power source 201 is 250 W, the power of the second power source 202 is 2 kW, the temperature of the silicon wafer substrate is 100°C, H₂ with a flow rate of 4000 sccm and SiH₄ with a flow rate of 10 sccm are used as the process gas, and the gas pressure in the process chamber is 0.8 Torr.

### Embodiment 8

Using the apparatus shown in FIG. 6 for operation, the amorphous silicon thin film is subjected to plasma interface treatment using the following process conditions: the electrode dimensions of the first discharge electrode 303 and the second discharge electrode 304 were 2m in length and 2m in width. The spacing between the cathode 303c and the second discharge electrode 304 is 30 mm, the distance between the third discharge electrode 308 and the fourth discharge electrode 309 is 10 mm, the ratio of the frequency of the first power source 301 to the frequency of the second power source 302 is 13.56 MHz: 60 MHz, the power of the first power source 101 is 5 kW, the power of the second power source is 1 kW, the temperature of the silicon wafer substrate is 190°C, H₂ with a flow rate of 20000 sccm and SiH₄ with a flow rate of 100 sccm are used as the process gas, and the gas pressure in the process chamber is 5 Torr.

The foregoing description is only illustrative of some of the preferred embodiments of the present disclosure and of the principles of the technology employed. It will be appreciated by a person skilled in the art that the scope of the present invention covered by the embodiments of the present disclosure is not limited to any particular combination of the features set forth above, but is intended to cover any combination of the features set forth above or their equivalents without departing from the spirit of the present invention. For example, the above-mentioned features and the technical features disclosed in the embodiments of the present disclosure (but not limited to) having similar functions are replaced with each other to form a technical solution.

## Claims

1. A large-area dual-frequency heterojunction solar cell thin film deposition method, wherein
the large-area dual-frequency heterojunction solar cell thin film deposition method at least comprises:
placing a silicon wafer to be deposited in a process chamber of a flat-plate coupled chemical vapor deposition;
introducing a process gas into the process chamber, the process gas comprising at least one of SiH₄, H₂, CO₂, NO₂, N₂, O₂, O₃, Ar, and NH₃;
generating a plasma by exciting and dissociating of the process gas through a radio frequency power supply system fed into the process chamber; and
transferring the plasma to the surface of the silicon wafer to be deposited under the electric field to form a silicon-based thin film or perform plasma interface treatment on the deposited silicon-based thin film; wherein
the radio frequency power supply system comprises a first power source, and a second power source with a higher frequency than the first power source, wherein the frequency of the first power source and the second power source ranges from 0.3 MHz to 200 MHz;
the radio frequency power supply system is electrically connected to a first discharge electrode, and the first discharge electrode comprises:
a cathode with multiple apertures structure, a cathode backplate enclosing a gas distribution space with the cathode, and a channel portion located at the center of the cathode backplate for gas to enter the gas distribution space;
the silicon wafer to be deposited is placed on a tray as a second discharge electrode, and the second discharge electrode is grounded;
during the thin film deposition, an electrode spacing formed between the cathode of the first discharge electrode and the second discharge electrode ranges from 5 mm to 50 mm;
the silicon wafer substrate temperature in the process chamber ranges from 100°C to 300°C; the gas pressure in the process chamber ranges from 0.2 Torr to 15 Torr;
the size of the first discharge electrode and the second discharge electrode ranges from 1 m to 4 m in length and from 1 m to 4 m in width; and
the power of the first power source ranges from 250 W to 60 KW, and the power of the second power source ranges from 250 W to 60 KW; and
the frequency ratio of the first power source to the second power source ranges from 1: 50 to 1: 1.5.

2. The large-area dual-frequency heterojunction solar cell thin film deposition method according to claim 1, wherein the flow rate of SiH₄ in the process gas ranges from 10 sccm to 10000 sccm.

3. The large-area dual-frequency heterojunction solar cell thin film deposition method according to claim 1, wherein the first power source and the second power source are fed together to the central region of the cathode backplate corresponding to the channel portion;
or, the second power source is fed to the central region of the cathode backplate corresponding to the channel portion, and the first power source is fed to the edge region of the cathode backplate;
or, the first power source is electrically connected to the first discharge electrode, a third discharge electrode and a fourth discharge electrode are suspended in a discharge region formed by the first discharge electrode and the second discharge electrode, the second power source is electrically connected to the third discharge electrode, and the fourth discharge electrode is grounded.

4. The large-area dual-frequency heterojunction solar cell thin film deposition method according to claim 1, wherein the turn-on time of the first power source and the second power source is different.

5. A large-area dual-frequency heterojunction solar cell thin film deposition apparatus for use in the large-area dual-frequency heterojunction solar cell thin film deposition method according to any one of claims 1 to 4, the large-area dual-frequency heterojunction solar cell thin film deposition apparatus comprising:
a discharge electrode composed of a first discharge electrode and a second discharge electrode for generating an electric field for dissociating a gas; the size of the discharge electrode ranges from 1 m to 4 m in length and from 1 m to 4 m in width; and
a process chamber for forming a region containing the discharge electrode;
wherein
the large-area dual-frequency heterojunction solar cell thin film deposition apparatus further comprises:
a first power source for outputting a power of a first frequency; and
a second power source for outputting a power of a second frequency; the first power source and the second power source being both fed into the process chamber.

6. The large-area dual-frequency heterojunction solar cell thin film deposition apparatus according to claim 5, the first discharge electrode comprising:
a cathode configured as a lowermost showerhead of the first discharge electrode, the process gas being ejected from the apertures;
a cathode backplate enclosing a gas distribution space with the cathode; and
a channel portion configured to have at least one intake channel for gas to enter the gas distribution space; the channel portion is provided at a central region of the cathode backplate and at least partially outside the process chamber.

7. The large-area dual-frequency heterojunction solar cell thin film deposition apparatus according to claim 5, wherein
the first power source and the second power source are electrically connected to the central region of the cathode backplate corresponding to the channel portion.

8. The large-area dual-frequency heterojunction solar cell thin film deposition apparatus according to claim 5, wherein
the second power source is electrically connected to the central region of the cathode backplate corresponding to the channel portion; and the first power source is electrically connected to an edge region of the cathode backplate.

9. The large-area dual-frequency heterojunction solar cell thin film deposition apparatus according to claim 8, wherein
the first power source is divided into four parts and electrically connected to the cathode backplate; wherein
the connection positions of the first power source and the cathode backplate are symmetrically arranged on two diagonals of the cathode backplate.

10. The large-area dual-frequency heterojunction solar cell thin film deposition apparatus according to claim 5, wherein
the first power source is electrically connected to the first discharge electrode, a third discharge electrode and a fourth discharge electrode are suspended in a discharge region formed by the first discharge electrode and the second discharge electrode, the second power source is electrically connected to the third discharge electrode, and the fourth discharge electrode is grounded, wherein the third discharge electrode and the fourth discharge electrode are strip antenna structure electrodes; the spacing between the first discharge electrode and the second discharge electrode ranges from 10 mm to 50 mm; and the spacing between the third discharge electrode and the fourth discharge electrode ranges from 5 mm to 45 mm.

11. The large-area dual-frequency heterojunction solar cell thin film deposition apparatus according to claim 5, wherein
the large-area dual-frequency heterojunction solar cell thin film deposition apparatus further comprises:
a matching device for adjusting the impedance of the circuit where it is located; at least one of the first power source and the second power source is electrically connected to the discharge electrode through the matching device.

12. The large-area dual-frequency heterojunction solar cell thin film deposition apparatus according to claim 5, wherein
the first power source and the second power source are respectively electrically connected to the discharge electrode via two different matching devices;
or, the first power source and the second power source are electrically connected to the discharge electrode through the same matching device.

13. An in-line continuous deposition production equipment, wherein
the in-line continuous deposition production equipment comprises the large-area dual-frequency heterojunction solar cell thin film deposition apparatus according to any one of claims 5 to 12.

14. A cluster type deposition production equipment, wherein
the cluster type deposition production equipment comprises the large-area dual-frequency heterojunction solar cell thin film deposition apparatus according to any one of claims 5 to 12.
